# EUROPÄISCHE PATENTANMELDUNG

(11) **EP 4 696 998 A1**
(43) Veröffentlichungstag der Anmeldung: **18.02.2026**
(21) Anmeldenummer: 24194266.3
(22) Anmeldetag: 13.08.2024
(51) Int. Cl.: G01K 11/3206, H05K 1/02

(54) **TEMPERATURMESSVORRICHTUNG UND -VERFAHREN**

(71) Anmelder: Siemens Aktiengesellschaft, 80333 München (DE)
(72) Erfinder: Wetzel, Ulrich, 91325 Adelsdorf (DE)
(74) Vertreter: Siemens Patent Attorneys

(57) **Zusammenfassung**

Die Erfindung betrifft eine Temperaturmessvorrichtung und ein Temperaturmessverfahren, ein Herstellungsverfahren für eine Temperaturmessvorrichtung sowie eine elektronische Baugruppe mit einer Temperaturmessvorrichtung, basierend auf einer optischen Temperaturerfassung.

Die Temperaturmessvorrichtung umfasst wenigstens einen optischen Wellenleiter (OF) angeordnet mit einem Trägermaterial (PCB), wobei der optische Wellenleiter eine Mikrogitterstruktur (FBG) aufweist, welche temperaturabhängiges Reflexions- und Transmissionsverhalten zeigt und mittels optischem Sensor abgetastet werden kann.

## Beschreibung

Die Erfindung betrifft eine Temperaturmessvorrichtung und ein Temperaturmessverfahren, ein Herstellungsverfahren für eine Temperaturmessvorrichtung sowie eine elektronische Baugruppe mit einer Temperaturmessvorrichtung, basierend auf einer optischen Temperaturerfassung.

### Stand der Technik

Die Messung beziehungsweise Abschätzung der Temperaturen in elektronischen Baugruppen ist wichtig für die Abschätzung von Lebensdauer und Zuverlässigkeit. Besonders die Kenntnis über die Temperaturen in Leistungsmodulen ist entscheidend für die Gewährleistung einer gewissen Robustheit der gesamten Umrichter-Baugruppe.

Wenn ein Motor beispielsweise aufgrund einer Fehlfunktion seine spezifizierte Temperaturgrenze überschreitet, können innerhalb kürzester Zeit irreparable Schäden im Antriebssystem auftreten. Darüber hinaus besteht die Gefahr eines möglichen Isolationsschadens im Antriebssystem. Ein gefährlicher Fehlerstromüberschlag vom Hochspannungskreis auf den Niedervoltkreis der Sensorik könnte die Folge sein. Die Konsequenzen reichen von lokalen Schäden an der internen Elektronik bis hin zu einer umfassenden Zerstörung des elektrischen Antriebssystems und angrenzender Komponenten, was wiederum das Risiko eines Stromschlags für die Anlagenbediener erhöht oder im schlimmsten Fall zu einem Brand im Maschinenraum führen kann.

Um dieses Szenario zu verhindern, wäre eine Chip-nahe Temperaturüberwachung ein Ansatz. Eine Chip-nahe Messung am Halbleiter ist mit gängigen Verfahren beziehungsweise verfügbaren Komponenten wie beispielsweise NTC (Negative Temperature Coefficient)-Thermistoren, KTY-Sensoren (spezielle Silizium-Halbleiter, die als Temperatursensoren mit positivem Temperaturkoeffizienten dienen) oder temperaturabhängigen Widerständen (etwa PT1000 Platinwiderstände) jedoch nur eingeschränkt möglich. Da diese Halbleiter mit hohen Spannungen und Strömen betrieben werden, ist eine galvanische Trennung der Sensorik von der zentralen Steuereinheit zwingend notwendig. Dies ist sehr aufwendig und aufgrund der elektrischen Vorgaben oft nicht durchführbar.

Insbesondere in der Leistungselektronik werden Temperaturmessungen bisher fernab vom Leistungshalbleitern durchgeführt - mit großem thermischen Widerstand zwischen Sensor und Messobjekt. Auch versucht man bei vereinfachten Betriebsmodi ein thermisches Modell zu nutzen, das die Temperatur der Leistungsmodule abschätzt, was prinzipbedingt auch eine große Toleranz aufweist.

Folglich stellt es sich als technisch erforderlich dar, eine verbesserte Lösung vorzuschlagen, welche die aus dem Stand der Technik bekannten Nachteile vermeidet. Insbesondere soll die vorzuschlagende Lösung eine zuverlässige und ungefährliche Temperaturerfassung in elektronischen Baugruppen ermöglichen.

Die auf eine Temperaturmessvorrichtung gerichtete Aufgabe wird durch die Merkmale des unabhängigen Patentanspruchs 1 gelöst. Die auf ein Temperaturmessvorfahren gerichtete Aufgabe wird durch die Merkmale des Patentanspruchs 8 gelöst. Zudem wird die auf eine elektronische Baugruppe gerichtete Aufgabe durch die Merkmale des Patentanspruchs 9 gelöst. In Patentanspruch 10 wird ein Herstellungsverfahren für eine elektronische Baugruppe mit Temperaturmessvorrichtung angegeben. Vorteile und Ausgestaltungen der Erfindung, die einzeln oder in Kombination miteinander einsetzbar sind, sind Gegenstand der Unteransprüche. In den Unteransprüchen sind weitere vorteilhafte Maßnahmen aufgelistet, die beliebig miteinander kombiniert werden können, um weitere Vorteile zu erzielen.

### Beschreibung der Erfindung

Vorgeschlagen wird demnach eine Temperaturmessvorrichtung für elektronische Baugruppen, aufweisend wenigstens einen optischen Wellenleiter angeordnet mit einem Trägermaterial, wobei der optische Wellenleiter eine Mikrogitterstruktur aufweist, welche temperaturabhängiges Reflexions- und Transmissionsverhalten zeigt und mittels optischem Sensor abgetastet werden kann.

Ein Vorteil der vorgeschlagenen Temperaturmessvorrichtung ist beispielsweise, dass eine Chip-nahe Temperaturüberwachung gewährleistet werden kann. Wenn eine kritische Übertemperatur schnell und zuverlässig erkannt wird und diese Informationen an die netztrennende Einheit weitergeleitet werden, kann eine elektronische Baugruppe, zum Beispiel ein Umrichter, rechtzeitig über eine Abschaltvorrichtung vom Netz getrennt werden.

Ein weiterer Vorteil ist die Nutzung der Temperaturparameter der einzelnen Leistungshalbleiter in einer regelungstechnischen Feedbackschleife, bei der zusätzlich zum Strom-Spannungsverhalten das thermische Modell der Schalteinheit mit abgeglichen wird. Auch dies erfordert eine zeitkritische Analyse der Temperaturtransienten am Halbleiter, was einen geringen thermischen Widerstand hin zum Sensor und eine nahe Messung am Halbleiter voraussetzt.

Es ergibt sich noch ein weiterer Vorteil aus der vorgeschlagenen Temperaturmessvorrichtung: Durch die Nutzung von kleinen Wellenleiter mit einer geringen Wärmekapazität kann ein hochdynamischer Temperatur-Verlauf im/am Halbleiter sehr gut erfasst und analysiert werden. Dank der Funktionsweise der Faserdehnung, kann eine Temperaturänderung mehrfach detektiert werden.

Im Kontext der Anmeldung sei unter einer elektronischen Baugruppe eine funktionale Einheit verstanden, die aus verschiedenen elektronischen Komponenten besteht, die auf einer Trägerplatte (meist einer Leiterplatte) montiert und miteinander verbunden sind. Zu den typischen Komponenten gehören Widerstände, Kondensatoren, Halbleiterbauelemente (wie Transistoren und Dioden), integrierte Schaltkreise (ICs) und andere elektronische Bauteile. Elektronische Baugruppen können in einer Vielzahl von Geräten und Systemen verwendet werden, von einfachen Konsumgütern bis hin zu komplexen industriellen Maschinen.

Unter einer leistungselektronische Baugruppe ist eine spezielle Art der elektronischen Baugruppe zu verstehen, die darauf ausgelegt ist, elektrische Energie zu steuern und zu wandeln. Diese Baugruppen werden verwendet, um hohe elektrische Leistungen zu verarbeiten, zu regeln und zu steuern. Sie bestehen aus Komponenten wie Leistungstransistoren (IGBTs, MOSFETs), Dioden, Thyristoren, Kondensatoren und Induktivitäten, die für den Betrieb bei hohen Spannungen und Strömen ausgelegt sind.

Anwendungsbereiche elektronischer Baugruppen liegen beispielsweise in der Signalverarbeitung, Kommunikation, Sensorik und allgemeiner Steuerungstechnik, Anwendungsbereiche leistungselektronischer Baugruppen können in speziellen Anwendungen liegen, die hohe elektrische Leistungen erfordern, wie beispielsweise Motorsteuerungen, Stromversorgungen, Wechselrichter und Umrichter. Eine elektronische Baugruppe beinhaltet meist Bauelemente für niedrige bis mittlere Leistungspegel, wie kleine Widerstände, Kondensatoren, Standard-Halbleiter und ICs. Leistungselektronische Baugruppen umfassen beispielsweise Bauelemente, die hohe elektrische Leistungen verarbeiten können, wie Leistungstransistoren (IGBTs, MOSFETs), Leistungsdioden, Thyristoren, Leistungskondensatoren und Hochstrom-Induktivitäten. Demnach müssen hohe Spannungen und Ströme verarbeitet werden. Leistungselektronische Baugruppen sind daher oft mit Kühlkörpern und anderen Wärmemanagement-Lösungen ausgestattet, um die durch die Leistungsverluste erzeugte Wärme abzuführen.

Vorzugsweise wird vorgeschlagen, dass das Trägermaterial eine flexible Leiterplatte ist. Dies hat den Vorteil der Biegbarkeit. Flexible, biegbare Bauelemente erhöhen vorteilhaft die Designmöglichkeiten.

Vorzugsweise wird vorgeschlagen, dass der optische Wellenleiter in das Trägermaterial integriert ist.

Unter dem Begriff integriert sei im Kontext der Anmeldung zu verstehen, dass der optische Wellenleiter so in das Trägermaterial eingebettet ist, dass die Oberfläche der Leiterplatte baugleich bestückt werden kann wie bei bisherigen Baugruppen ohne optische Temperaturdetektion. Er ist also so in der Leiterplatte eingefasst, dass es nicht zu Veränderungen an der Außengeometrie der Leiterplatte kommt. Dazu kann, wie nachfolgend noch beschrieben, eine optische Faser in einer Kavität eingebettet vorliegen oder eine elektro-optische Leiterplatte genutzt werden, in der der optische Wellenleiter integriert vorliegt. Vorzugsweise wird vorgeschlagen, dass der optische Wellenleiter eine optische Faser ist. Insbesondere ist der optische Wellenleiter eine diskrete optische Faser.

Eine optische Faser ist beispielsweise ein dünner Strang aus Glas oder Kunststoff, der Lichtsignale zur Datenübertragung nutzt. Im Kern der Faser wird das Licht durch Totalreflexion gehalten, da der Kern von einem Mantel mit geringerem Brechungsindex umgeben ist. Eine äußere Schutzschicht bewahrt die Faser vor physischen Schäden. Optische Fasern bieten hohe Datenübertragungsgeschwindigkeiten, geringe Signalverluste über lange Distanzen und sind unempfindlich gegen elektromagnetische Störungen. Datenübertragung in der Telekommunikation, Medizin, Industrie und in Datenzentren erfolgt mittels optischer Fasern effizient und zuverlässig.

Eine diskrete optische Faser ist zudem in einzelne, getrennte Abschnitte oder Segmente unterteilt, um bestimmte Eigenschaften oder Funktionen zu erfüllen. Im Gegensatz zu kontinuierlichen optischen Fasern, die über ihre gesamte Länge hinweg gleichmäßige Eigenschaften aufweisen, weisen diskrete optische Fasern unterschiedliche Brechungsindizes, Materialien oder geometrische Strukturen in ihren einzelnen Segmenten auf. Diese diskreten Strukturen können eingesetzt werden, um spezielle optische Effekte zu erzielen oder die Faser für spezifische Anwendungen zu optimieren. Beispielsweise können sie verwendet werden, um bestimmte Wellenlängen des Lichts herauszufiltern oder zu verstärken und somit präzise Messungen von Temperatur, Druck oder anderen physikalischen Größen zu ermöglichen.

Vorzugsweise wird vorgeschlagen, dass das Trägermaterial eine elektro-optische Leiterplatte ist und der optische Wellenleiter in der Leiterplatte integriert vorliegt.

Einer der Vorteile dieser Ausführungsform der Erfindung ist deren UV-Beständigkeit. Sie kann in einem weiten Wellenlängenbereich, bereits für 50µm-Wellenleiter eingesetzt werden. Zudem weist die vorgeschlagene Lösung eine geringe Alterung auf und eine circa 10% höhere Dämpfung bei 470nm, bei 6 Jahren unter 80°C. Zudem hat die vorgeschlagene Lösung den Vorteil einer hohen Polarisationstreue, was sie besonders für Sensorik-Anwendungen gut eignet. Sie kann demnach vorteilhaft für eine optische Energieübertragung verwendet werden, besonders vorteilhaft im Bereich über 80 mW. Zudem ist die vorgeschlagene Lösung singlemodefähig, insbesondere im Bereich um 50µm.

In Leiterplatten integrierte Wellenleiter sind kommerziell erhältlich, können lithographisch hergestellt oder gedruckt werden. Weitere Vorteile sind der kompakte Aufbau und die geringe Wärmekapazität eines derartigen Sensors, sowie die schnelle Signalweiterleitung.

Vorzugsweise wird vorgeschlagen, dass der optische Wellenleiter ein gedruckter Wellenleiter ist.

Diese Temperaturmessvorrichtung hat insbesondere den Vorteil, sehr günstig herstellbar zu sein, flexible und starre Aufbauten zu ermöglichen, mittels herkömmlicher Leiterplatten realisierbar zu sein, insbesondere durch Integration mittels Lamination.

Vorzugsweise wird vorgeschlagen, eine optische Auswerteeinheit, insbesondere ein Spektrometer, umfasst ist.

Beispielsweise können niedrigpreisige Varianten von Spektrometern eingesetzt werden, die direkt mit verbaut werden können.

Nach einer weiteren Lehre gemäß der Erfindung, der eigenständige Bedeutung zukommt, wird ein Temperaturmessverfahren mittels einer Temperaturmessvorrichtung nach einer der vorstehend beschriebenen Varianten vorgeschlagen, bei welchem ein optisches Signal in einen optischen Wellenleiter ausgesendet wird und das temperaturabhängige Reflexions- und Transmissionsverhalten einer Mikrogitterstruktur im optischen Wellenleiter mittels eines optischen Sensors abgetastet wird. Auf Ausführungen zur vorschlagsgemäßen Temperaturmessvorrichtung darf verwiesen werden.

Es wird also ein optisches Signal in einen optischen Wellenleiter abgesendet, der eine Mikrogitterstruktur aufweist, und das temperaturabhängig reflektierte und/oder transmittierte optischen Signals an und/oder durch die Mikrogitterstruktur mittels eines optischen Sensors empfangen, beziehungsweise abgetastet. Ein Vorteil dieses Messverfahrens besteht darin, dass eine Temperaturmessung direkt am Chip vorgenommen werden kann. Die Messung kann sehr schnell erfolgen. Besonders vorteilhaft ist die galvanische Trennung der Sensoreinheit von der Bauteilelektronik. Zudem erfolgt über die optische Messmethode der Temperatur keine induktive Beeinflussung des elektronischen Bauteils.

Nach einer weiteren Lehre gemäß der Erfindung, der ebenfalls eigenständige Bedeutung zukommt, wird eine elektronische Baugruppe beansprucht, umfassend eine Temperaturmessvorrichtung nach einer der vorstehend beschriebenen Varianten, auf welche Ausführungen der Temperaturmessvorrichtung und des Temperaturmessverfahren, verwiesen werden darf.

Nach einer weiteren Lehre gemäß der Erfindung, der ebenfalls eigenständige Bedeutung zukommt, wird ein Herstellungsverfahren für eine elektronischen Baugruppe beansprucht, umfassend eine Einbringung einer Gitterstruktur in einen optischen Wellenleiter und eine Anordnung eines optischen Wellenleiters mit einem Trägermaterial. Auf alle Ausführungen zu der vorschlagsgemäßen Temperaturmessvorrichtung, dem Temperaturmessverfahren und der vorschlagsgemäßen elektronische Baugruppe darf verwiesen werden.

Vorzugsweise wird vorgeschlagen, dass die Einbringung mittels eines Femto-Sekunden-Lasers erfolgt.

In einer weiteren vorteilhaften Ausführungsform wird vorgeschlagen, dass eine Integration des optischen Wellenleiters (OF) in das Trägermaterial (PCB) erfolgt. Dazu wird als vorteilhafte Ausführungsform vorgeschlagen, dass die Integration des optischen Wellenleiters in das Trägermaterial durch Einbetten einer optischen Faser in eine Kavität im Trägermaterial erfolgt. Alternativ wird vorzugsweise vorgeschlagen, dass die Integration des optischen Wellenleiters in das Trägermaterial durch einen lithographischen Herstellungsprozess erfolgt.

In einer weiteren vorteilhaften Variante wird vorzugsweise vorgeschlagen, dass die Integration des optischen Wellenleiters in das Trägermaterial durch ein Druckverfahren erfolgt.

Dies hat insbesondere die Vorteile, dass der auf diese Weise integrierte optische Wellenleiter sehr kostengünstig herstellbar ist. Mittels dieser Herstellungsweise sind flexible und starre Aufbauten möglich. Auch kann das Verfahren zur Integration optischer Wellenleiter in beziehungsweise auf herkömmliche Leiterplatten genutzt werden.

### Figurenbeschreibung

Im Folgenden wird die Erfindung anhand der in den Figuren dargestellten Ausführungsbeispiele näher beschrieben. In den Ausführungsbeispielen und Figuren können gleiche oder gleich wirkende Elemente jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, zur besseren Darstellbarkeit und/oder zum besseren Verständnis im Verhältnis größer dimensioniert dargestellt sein. Merkmale, Eigenschaften und Vorteile der vorliegenden Erfindung werden in der nachfolgenden Beschreibung unter Bezugnahme auf die beiliegenden Figuren erläutert. Darin zeigen schematisch:
- Figur 1: eine Explosionsansicht einer elektronischen Baugruppe BA mit einem optischen Wellenleiter OF zur Temperaturmessung entlang der Bauteile ch,
- Figur 2: eine Durchsicht durch eine elektronische Baugruppe BA mit einem optischen Wellenleiter OF zur Temperaturmessung entlang der Bauteile ch,
- Figur 3: eine optische Faser OF, in den mittels Laser eine Gitterstruktur FBG eingeprägt wird,
- Figur 4: eine optische Faser OF mit visualisierter Spektralaufspaltung am optischen Gitter FBG,
- Figur 5: eine Seitenansicht auf eine optische Faser OF mit Gitter FBG und Reflexions-ref und Transmissionsspektrum tr,
- Figur 6: eine elektro-optische Leiterplatte EOCB in perspektivischer Darstellung mit integrierten optischen Wellenleitern OF und
- Figur 7: eine Schnittansicht einer elektro-optischen Leiterplatte EOCB.

Obwohl die Erfindung im Detail durch bevorzugte Ausführungsbeispiele näher illustriert und beschrieben wurde, ist die Erfindung nicht durch die offenbarten Beispiele eingeschränkt. Variationen hiervon können vom Fachmann abgeleitet werden, ohne den Schutzumfang der Erfindung, wie er durch die Patentansprüche definiert wird, zu verlassen.

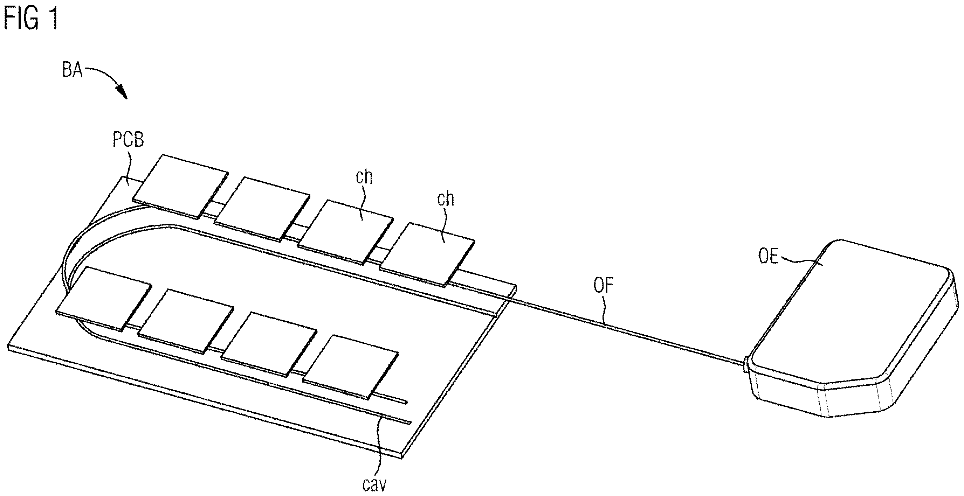

In der Figur 1 wird in einer Explosionsdarstellung schematisch gezeigt, wie in einem Trägermaterial PCB, insbesondere einer Leiterplatte (PCB - printed circuit board), eine Kavität cav verläuft, in welche ein optischer Wellenleiter OF eingebettet wird. Diese Kavität cav kann mechanisch oder lithographisch erzeugt werden. Die Einbettung des optischen Wellenleiters OF kann mechanische erfolgen, zum Beispiel bei einer optischen Faser wie etwa einer Glasfaser, oder lithographisch oder mittels Druckverfahren, wie beispielsweise bei einstrukturierten optischen Wellenleitern in elektro-optischen Leiterplatten EOCB.

Des Weiteren ist der optischen Wellenleiter OF gezeigt, wie er entlang der Bauelemente ch verläuft, mit denen die Leiterplatte PCB bestückt wird. Dies können verschiedene elektronische Bauelemente, insbesondere Halbleiterchips sein. Träger PCB und Bauelemente ch bilden eine Baugruppe BA, insbesondere eine leistungselektronische Baugruppe.

Der optische Wellenleiter OF ist mit einem optischen Empfänger OE verbunden. Dieser kann als weiteres Modul teil der Baugruppe BA sein. Alternativ kann er außerhalb der Baugruppe BA positioniert sein. Der optische Empfänger OE kann beispielsweise ein Spektrometer sein, insbesondere ein FBG X100-Spektrometer, welches als Spektrometer-Modul kommerziell erhältlich ist.

Die Darstellung verdeutlich zudem zwei der Vorteile der erfindungsgemäßen optischen Temperaturmessung: Es kann auf Temperatursensoren verzichtet werden, die eine elektrische Zuleitung bräuchten. Diese sind insbesondere bei leistungselektronischen Baugruppen ungeeignet, da die Leistunghalbleiter im Hochvoltbereich arbeiten. Zudem können mit nur einer optischen Faser kann alle Chips der Baugruppe beziehungsweise der Leiterplatte gemessen werden. Ein optischer Wellenleiter OF kann komplett durchgezogen werden.

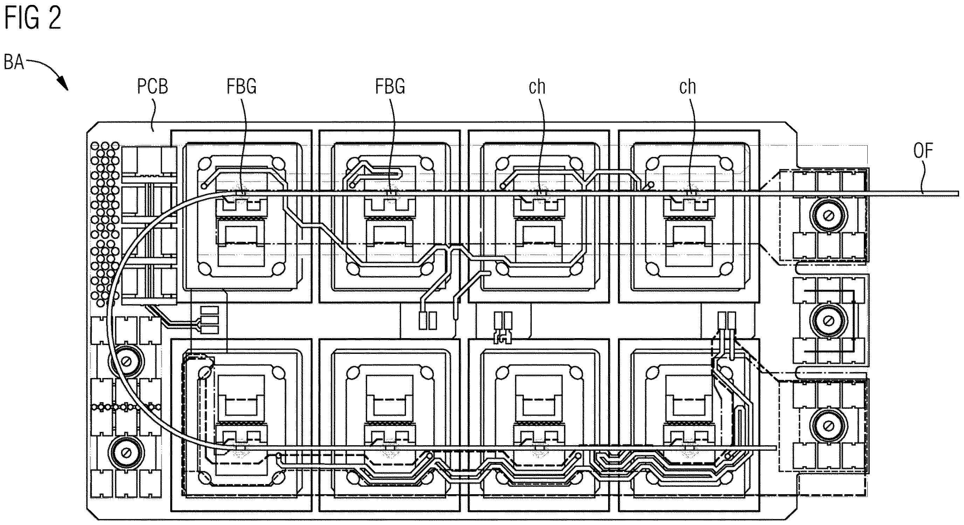

Figur 2 zeigt eine Durchsicht durch eine elektronische Baugruppe BA mit einem optischen Wellenleiter OF zur Temperaturmessung entlang der Bauteile ch. Die Durchsicht verdeutlicht die Einbettung der optischen Faser OF in die Leiterplatte PCB, welche dann als Träger wie gewöhnlich mit Bauelementen ch, insbesondere Halbleiterchips, bestückt werden kann. Es sind schematisch elektrische Anbindungen an die Leiterplatte PCB sowie elektrische Leitungen zwischen den Bauelementen ch gezeigt. Die optischen Gitter FBG, die im optischen Wellenleiter OF eingebracht sind, sind beispielsweise eingebrachte Mikrostrukturen, sogenannte Fiber-Bragg-Gratings. Diese sind zweckdienlicherweise so eingebracht, dass sie jeweils unter einem Bauelement ch positioniert sind, dessen Temperatur sie dann erfassen. Diese Gitter werden mittels optischem Sensor OE abgetastet.

Je nach transmittiertem tr beziehungsweise reflektiertem Signal ref, kann auf die Temperatur am Gitter FBG rückgeschlossen werden.

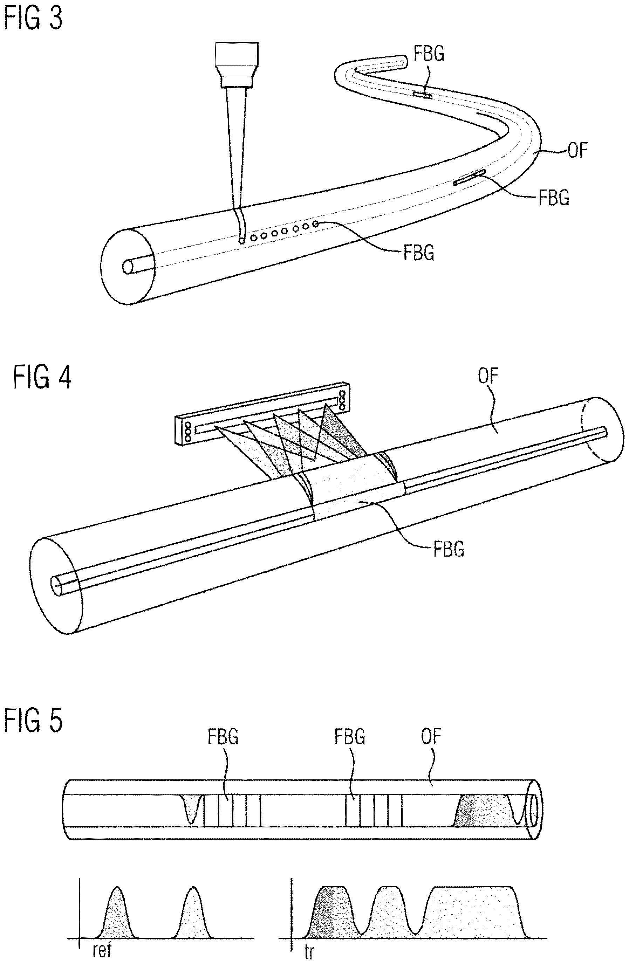

In den Figuren 3 bis 5 sind Abschnitte eines optischen Wellenleiters OF, insbesondere einer Glasfaser gezeigt. Die Figur 3 verbildlicht schematisch, wie relativ einfach, mittels eines Lasers, bevorzugt eines Femtosekunden-Lasers, eine Mikrogitterstruktur FBG in den Wellenleiter OF eingeprägt wird.

Durch die Nutzung von kleinen Wellenleiter mit geringem Durchmesser und mit einer geringen Wärmekapazität kann ein hochdynamischer Temperatur-Verlauf an den Messpunkten erfasst werden. Die Messpunkte befinden sich bevorzugt unmittelbar an den Bauelementen ch, insbesondere den Halbleiterchips. Durch die Erfassung dynamischer Temperaturverläufe sind besonders detaillierte Rückschlüsse möglich.

In den Figuren 4 und 5 ist verdeutlicht, wie die eingeprägte Materialveränderung in der Glasfaser wie ein optisches Gitter fungiert. Ein im Wellenleiter OF transportiertes optisches Signal wird am Gitter unterschiedlich transmittiert und reflektiert. Das Transmissionsspektrum tr zusammen mit dem Reflexionsspektrum ref sind charakteristisch für die Gitterabstände, welche wiederum temperaturabhängig sind. Dies liegt an der temperaturabhängigen Materialausdehnung des optischen Leiters OF.

Hier wird noch einmal der Vorteil deutlich, dass diese Form der optischen Temperaturmessung, insbesondere mit einer optischen Faser OF als Wellenleiter, auch in elektronischen Baugruppen BA oder allgemein auf Schaltungsträgers, auch außerhalb der Leiterplatte stattfinden kann. Es entstehen neue Designfreiheiten für integrierte Temperaturmessung.

Die spektroskopische Auswertung beruht darauf, Licht mit einer vorgebbaren Bandbreite an Wellenlängen in den Wellenleiter einzukoppeln und dann die Reflexion an den eingebrachten Gittern FBG zu erfassen und auszuwerten. Dies kann bevorzugt mittels eines Spektrometers, insbesondere eines einfachen Spektrometermoduls erfolgen. Die erfassten Spektrallinien korrespondieren zur Temperatur am Gitter FBG, also am Messpunkt. Es gibt auch miniaturisierte Spektrometermodule, die als Zukaufteil verbaut werden können, um eine kostengünstige optische Temperaturmessung zu realisieren.

Hier sollte je nach Anwendung entschieden werden, wie wichtig die Genauigkeit Temperaturmessung ist. Ob es sich nur um eine Detektion eines Grenz-Temperaturwertes handelt oder ob ein Temperaturgradient erfasst und ausgewertet werden soll. Oder ob es eher um eine vereinfachte und kostengünstige Integration einer Temperaturmessung geht.

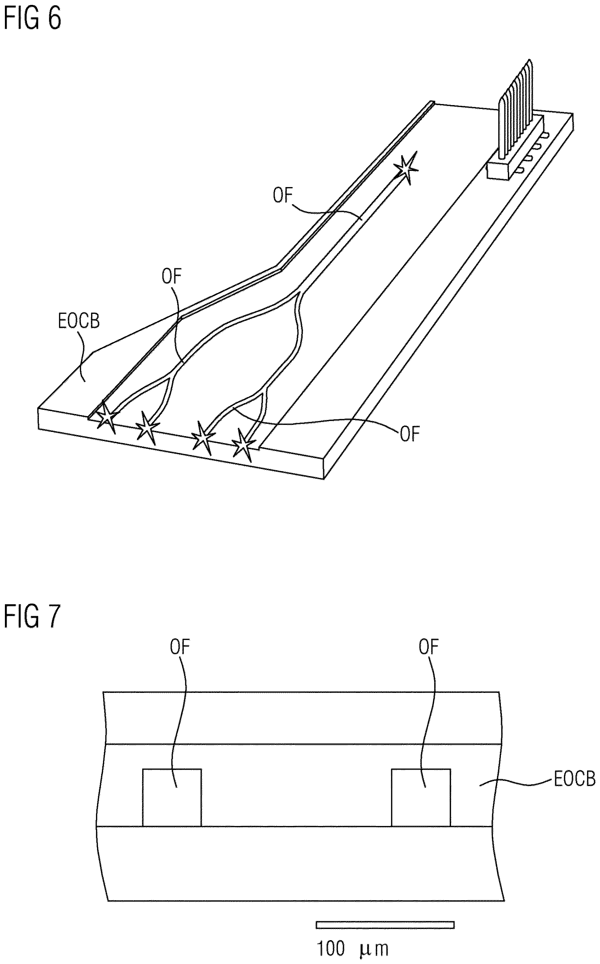

In den Figuren 6 und 7 schließlich sind noch optisch modifizierte Wellenleiter OF innerhalb einer elektro-optischen Leiterplatte EOCB gezeigt. Die Wellenleiter OF der sogenannten electro-optical Circuit boards EOCB werden bevorzugt an den Positionen der Leistungshalbleiter dh mit Fiber-Bragg-Gratings FBG ausgestattet. So kann über ein geeignetes optisches Auswertesystem die Temperatur an jedem Halbleiter erfasst werden. Als optisches Auswertesystem kommt bevorzugt ein vereinfachtes Spektrometer OE zum Einsatz. Somit kann die Temperatur an jedem Chip ch schnell gemessen werden.

Die Verwendung von wellenleiter-integrierten Temperatursensoren bietet demnach eine Reihe von Vorteilen. Zunächst ermöglicht die vorgeschlagene Lösung eine Messung in unmittelbarer Nähe zum Messobjekt, wie beispielsweise einem Halbleiter-Chip ch. Dank der Verwendung kleiner Wellenleiter OF mit geringer Wärmekapazität kann der hochdynamische Temperaturverlauf im oder am Halbleiter ch präzise erfasst und analysiert werden. Zudem lassen sich die Fiber Bragg Gratings FBG durch bewährte Herstellungsverfahren, wie das Schreibverfahren mit einem Femtosekundenlaser, einfach in den Wellenleiter integrieren. Der kompakte Aufbau und die geringe Wärmekapazität des Sensors tragen ebenfalls zu seiner Effizienz bei. Darüber hinaus nutzt die vorgeschlagene Lösung die Vorteile elektro-optischer Leiterplatten EOCB für eine schnelle Signalweiterleitung, was die Gesamtleistung des Systems weiter verbessert.

### Bezugszeichen:

- BA: elektronische Baugruppe, insbesondere leistungselektronische Baugruppe
- OF: optischer Wellenleiter, insbesondere optische Faser oder einstrukturierter Wellenleiter
- OE: Optischer Empfänger, beispielsweise Spektrometer
- cav: Kavität
- PCB: Trägermaterial, insbesondere Leiterplatte (printed circuit board)
- ch: Chip, Bauelement
- EOCB: elektro-optische Leiterplatte (electro-optical circuit board)
- ref: reflektiertes optisches Signal
- tr: transmittiertes optisches Signal
- FBG: Gitter, in eine optische Faser OF eingebrachte Mikrostruktur (Fiber-Bragg-Grating), die mittels optischem Sensor abgetastet werden kann

## Patentansprüche

1. Temperaturmessvorrichtung für elektronische Baugruppen (BA), aufweisend wenigstens einen optischen Wellenleiter (OF) angeordnet mit einem Trägermaterial (PCB), wobei der optische Wellenleiter eine Mikrogitterstruktur (FBG) aufweist, welche temperaturabhängiges Reflexions- und Transmissionsverhalten zeigt und mittels optischem Sensor (OE) abgetastet werden kann.

2. Temperaturmessvorrichtung nach Anspruch 1, wobei das Trägermaterial (PCB) eine flexible Leiterplatte ist.

3. Temperaturmessvorrichtung nach Anspruch 1 oder 2, wobei der optische Wellenleiter (OF) in das Trägermaterial (PCB) integriert ist.

4. Temperaturmessvorrichtung nach einem der vorstehenden Ansprüche, wobei der optische Wellenleiter (OF) eine optische Faser ist.

5. Temperaturmessvorrichtung nach einem der vorstehenden Ansprüche, wobei das Trägermaterial (PCB) eine elektro-optische Leiterplatte (EOCB) ist und der optische Wellenleiter (OF) in der Leiterplatte integriert vorliegt.

6. Temperaturmessvorrichtung nach Anspruch 3 oder 5, wobei der optische Wellenleiter (OF) ein gedruckter Wellenleiter ist.

7. Temperaturmessvorrichtung nach einem der vorstehenden Ansprüche, umfassend eine optische Auswerteeinheit (OE), insbesondere ein Spektrometer.

8. Temperaturmessverfahren mittels einer Temperaturmessevorrichtung nach einem der vorstehenden Ansprüche 1 bis 7, umfassend die Absendung eines optischen Signals in einen optischen Wellenleiter (OF), der eine Mikrogitterstruktur (FBG) aufweist, und die Abtastung des temperaturabhängig reflektierten und/oder transmittierten optischen Signals an und/oder durch die Mikrogitterstruktur (FBG) mittels eines optischen Sensors (OE).

9. Elektronische Baugruppe (BA) umfassend eine Temperaturmessvorrichtung nach einem der Ansprüche 1 bis 7.

10. Herstellungsverfahren für eine elektronische Baugruppe (BA) nach Anspruch 9, insbesondere für eine leistungselektronische Baugruppe oder einen Schaltungsträger, umfassend eine Einbringung einer Gitterstruktur (FBG) in einen optischen Wellenleiter (OF) und eine Anordnung eines optischen Wellenleiters (OF) mit einem Trägermaterial (PCB).

11. Herstellungsverfahren nach Anspruch 10, wobei die Einbringung mittels eines Femto-Sekunden-Lasers erfolgt.

12. Herstellungsverfahren nach Anspruch 10 oder 11, wobei eine Integration des optischen Wellenleiters (OF) in das Trägermaterial (PCB) erfolgt.

13. Herstellungsverfahren nach Anspruch 12, wobei die Integration des optischen Wellenleiters (OF) in das Trägermaterial (PCB) durch Einbetten einer optischen Faser in eine Kavität (cav) im Trägermaterial erfolgt.

14. Herstellungsverfahren nach Anspruch 12, wobei die Integration des optischen Wellenleiters (OF) in das Trägermaterial (PCB) durch einen lithographischen Herstellungsprozess erfolgt.

15. Herstellungsverfahren nach Anspruch 12, wobei die Integration des optischen Wellenleiters (OF) in das Trägermaterial (PCB) durch ein Druckverfahren erfolgt.
